# EUROPÄISCHE PATENTANMELDUNG

(11) **EP 4 224 353 A1**
(43) Veröffentlichungstag der Anmeldung: **09.08.2023**
(21) Anmeldenummer: 22155614.5
(22) Anmeldetag: 08.02.2022
(51) Int. Cl.: G06F 30/15, G06F 30/20

(54) **VERFAHREN ZUM ERZEUGEN EINES VIRTUELLEN MODELLS EINES BAUTEILS, COMPUTERSYSTEM, COMPUTERPROGRAMMPRODUKT**

(71) Anmelder: Siemens Industry Software NV, 3001 Leuven (BE)
(72) Erfinder: Bergmann, Dorlis, 90607 Rückersdorf (DE); Liu, Kai, 90562 Heroldsberg (DE); von Schwerin, Andreas, 81735 München (DE)
(74) Vertreter: Siemens Patent Attorneys

(57) **Zusammenfassung**

Verfahren zum Erzeugen eines virtuellen Modells eines Bauteils (CMP) unter Verwendung einer computergestützten Entwurfsumgebung (CAD), die eine Entwurfsdatenbank (DDB) umfasst, wobei die Entwurfsdatenbank (DDB) zum Speichern von Entwürfen (DSG) verwendet wird, wobei die Entwurfsumgebung (CAD) vordefinierte Entwurfselemente (DEL) zur Verfügung stellt, und wobei zumindest einige der Entwürfe (DSG) vordefinierte Entwurfselemente (DEL) umfassen.
Zudem ist vorgesehen, dass eine Designdatenbank (KGD) die Informationen aus der Entwurfsdatenbank (DDB) über Entwürfe (PRD) enthält, und dass
(b) das Verfahren in einer Entwurfsphase (DSH) weitere Schritte umfasst:
(b1) Auswahl mindestens eines Entwurfselements (DEL),
(b2) Ermitteln von Entwürfen (PRD), die das ausgewählte Entwurfselement (DEL) enthalten, aus der Designdatenbank (KGD),
(b3) Anzeigen von Informationen betreffend mindestens einen der ermittelten Entwürfe (PRD).

## Beschreibung

Die Erfindung betrifft ein Verfahren zum Erzeugen eines virtuellen Modells eines Bauteils unter Verwendung einer computergestützten Entwurfsumgebung, die eine Entwurfsdatenbank umfasst, wobei die Entwurfsdatenbank zum Speichern von Entwürfen verwendet wird, wobei die Entwurfsumgebung vordefinierte Entwurfselemente zur Verfügung stellt, wobei zumindest einige der Entwürfe vordefinierte Entwurfselemente umfassen.

Eine derartige computergestützte Entwurfsumgebung ist beispielsweise die kommerzielle Simulationssoftware Simcenter Amesim. Diese wird für die Modellierung und Analyse von Mehrdomänensystemen verwendet. Simcenter Amesim umfasst eine Reihe von Werkzeugen, die zur Modellierung, Analyse und Vorhersage der Leistung von mechatronischen Systemen verwendet werden. Die Modelle werden mit nichtlinearen, zeitabhängigen analytischen Gleichungen beschrieben, die das hydraulische, pneumatische, thermische, elektrische oder mechanische Verhalten des Systems darstellen. Im Vergleich zur 3D-CAE-Modellierung bietet dieser Ansatz die Möglichkeit, das Verhalten von Systemen zu simulieren, bevor eine detaillierte CAD-Geometrie verfügbar ist, und wird daher zu einem früheren Zeitpunkt im Systementwurfszyklus oder V-Modell eingesetzt.

Die Erstellung eines Modells in einer computergestützten Entwurfsumgebung wie Simcenter Amesim oder einer computergestützten Konstruktionssoftware wie Simcenter NX für einen Anwendungsfall mit einer Reihe von komplexen Entwurfselementen erfordert vom Ingenieur einen erheblichen Aufwand, die richtigen Entwurfselemente oder Modelle aus der Bibliothek auszuwählen und Parameter für diese Entwurfselemente festzulegen. Für einen Anfänger oder Gelegenheitsbenutzer der Softwareanwendung ist dies mühsam und sogar fehleranfällig.

Bisher sind für den Umgang mit derartigen computergestützten Entwurfsumgebungen umfangreiche Schulungen unerfahrener Benutzer und Unterstützung durch Experten erforderlich. Regelmäßig ist ein aufwändiges Studium vorhandener Entwürfe, Bibliotheksdokumentationen und Benutzerhandbücher notwendig, um ein geeignetes Entwurfselement für den beabsichtigten Zweck zu finden.

Ausgehend von den Problemen und Nachteilen des Standes der Technik hat es sich die Erfindung zur Aufgabe gemacht, ein Verfahren eingangs definierter Art derart weiterzubilden, dass die erläuterten Probleme und Nachteile vermieden werden.

Zur erfindungsgemäßen Lösung der Aufgabe wird ein Verfahren eingangs definierter Art mit den zusätzlichen Merkmalen des Kennzeichens des unabhängigen Anspruchs 1 vorgeschlagen. Daneben schlägt die Erfindung ein entsprechendes Computerprogrammprodukt vor. Die jeweils abhängigen Unteransprüche beinhalten vorteilhafte Weiterbildungen der Erfindung.

Im Einzelnen wird das eingangs definierte Verfahren erfindungsgemäß fortgebildet, indem vorgesehen ist, dass eine Designdatenbank Informationen aus der Entwurfsdatenbank über Entwürfe enthält. Weiterhin sind in einer Entwurfsphase weitere Schritte vorgesehen:
(b1) Auswählen mindestens eines Entwurfselements,
(b2) Ermitteln von Entwürfen, die das ausgewählte Entwurfselement enthalten, aus der Designdatenbank,
(b3) Anzeigen von Informationen betreffend mindestens einen der ermittelten Entwürfe.

Im Folgenden werden spezifische Begriffsbedeutungen erläutert, die zum besseren Verständnis der Erfindung nützlich sind.

Der Begriff Bauteil ist im weitesten Sinne zu verstehen und kann insbesondere als eine komplexe Baugruppe oder ein komplettes Produkt bestehend aus mehreren Einzelteilen angesehen werden. Beispiele hierfür sind vollständige Autos, Schiffe, Flugzeuge beziehungsweise Baugruppen oder Bauteile davon.

Computer-Aided Design ist die Verwendung von Computern (oder Workstations), um bei der Erstellung, Änderung, Analyse oder Optimierung eines Designs zu helfen. CAD-Software wird verwendet, um die Produktivität des Konstrukteurs zu steigern, die Qualität der Konstruktion zu verbessern, die Kommunikation durch Dokumentation zu verbessern und eine Datenbank für die Fertigung zu erstellen. Oft wird CAD im engeren Sinne verstanden und meint ausschließlich die computergestützte Erstellung und Modifikation des geometrischen Modells. Die Erfindung wendet ein breiteres Verständnis von CAD an. Unter CAD werden hierunter alle computergestützten Tätigkeiten in einem Konstruktionsprozess verstanden, einschließlich geometrischer Modellierung, Berechnung, Simulation und anderer Informationserfassung und -bereitstellung, von der Konzeptentwicklung bis zur Übertragung auf die Produktion oder Fertigung.

Im Wortlaut der Erfindung können Daten aus einer Entwurfsdatenbank Bilder, Wissen, vorhandene Entwürfe, Benutzerhandbücher, Dokumentationen oder zusätzliche Informationen umfassen.

Bei einer Graphdatenbank sind die Daten in einer Netzwerkstruktur angelegt, wobei Graphen benutzt werden, um hierarchische und/oder vernetzte Informationen darzustellen und abzuspeichern. Ein solcher Graph besteht aus Knoten und (gerichteten oder ungerichteten) Kanten. Die Kanten sind Verbindungen zwischen den Knoten. Bekannte Konzepte für Graphdatenbanken sind das Resource Description Framework und Labeled-Property Graph.

Bei einem Knowledge-Graph handelt es sich um eine Graphdatenbank, in der "Wissen" gespeichert ist. Infolge des unscharfen Begriffs des "Wissens" ist dieser Begriff nicht eindeutig von anderen Graphdatenbanken abgegrenzt.

Ein Knowledge-Graph hat in der Regel diese Merkmale:
- Elemente sind semantisch beschrieben,
- mittels einer Ontologie kann den Daten eine Bedeutung zugeschrieben werden.

Eine Datenerhebungsphase ist bevorzugt der Entwurfsphase vorgelagert, kann aber auch parallel und/oder auch abwechselnd zueinander ablaufen, so dass besonders bevorzugt die Entwurfsdatenbank um weitere Entwürfe ergänzt wird.

Entwurfselemente sind technische Module, die bevorzugt als physikalische Ersatzmodelle gestaltet sind. In der computergestützten Entwurfsumgebung werden diese Entwurfselemente dem Benutzer als Funktionen, Programme, Module oder Objekte zur Verfügung gestellt, um diese ggf. miteinander zu kombinieren und auf diese Weise komplexere Systeme und Prozesse abzubilden. In der Regel können diese Entwurfselemente parametriert ausgebildet sein und können bevorzugt aus mindestens einer Eingabe (Input) mindestens eine Ausgabe (Output) erzeugen.

Ein Ermitteln der in einem Entwurf enthaltenen Entwurfselemente bedeutet zum Beispiel, dass der Typ der Elemente und bevorzugt zusätzlich eine etwaige Parametrierung des Entwurfselements ermittelt werden. Die Anordnung der ermittelten Entwurfselemente in einem Entwurf kann bevorzugt die Anordnung der einzelnen Elemente zueinander und deren funktionale Verknüpfung miteinander umfassen, besonders bevorzugt auch die Anordnung bzw. die Position in einem jeweiligen Bild bzw. der Bilddatei eines Entwurfs, zum Beispiel derart, dass es einem Benutzer möglich ist, mittels eines Cursors mit diesem Bild auf einem Bildschirm zu interagieren, so dass Informationen über die speziellen abgebildeten Entwurfselemente angezeigt werden.

Mittels der computergestützten Entwurfsumgebung erstellte Entwürfe enthalten in der Regel zumindest einige vordefinierte Entwurfselemente bzw. mindestens ein vordefiniertes Entwurfselement, welches dem Benutzer mittels einer Entwurfselementensammlung in der computergestützten Entwurfsumgebung zur Verfügung gestellt wird.

Eine Entwurfsdatenbank dient den Benutzern der computergestützten Entwurfsumgebung zum Ablegen, Abspeichern oder Zwischenspeichern von angefangenen oder fertiggestellten Entwürfen. In der Regel sind diese Entwürfe mehreren Benutzern zumindest mit Leserechten zugänglich.

Eine Datenbank, die als Graphdatenbank ausgebildet ist, insbesondere ein Knowledge-Graph, sieht die Ablage der einzelnen Elemente bzw. Entitäten in der Regel nicht in jedem beliebigen Format vor, sondern fordert die Einhaltung vorgegebener Formatierungsbedingungen. Für graphische Elemente bedeutet das in der Regel, eine Umwandlung in eine Zeichenkette (Serialization into string).

Die erfindungsgemäße Designdatenbank ist bevorzugt als Graphdatenbank, besonders bevorzugt als Knowledge-Graph-Design-Sammlung ausgebildet.

Vorliegend erfolgt ein Anzeigen von Informationen, wenn es nicht anders angegeben ist, mittels einer Anzeigeeinheit, also bevorzugt mittels eines Bildschirms, eines Monitors oder einer optischen Anzeigeeinheit.

Eingangs oder im Verlauf des erfindungsgemäßen Verfahrens hat der Benutzer die Möglichkeit vorbestimmte Kriterien für die Arbeit zu bestimmen, um eine Unterstützung mittels des Verfahrens besonders effizient zu gestalten. Hierzu können Gruppenkriterien für zum Beispiel eine Untergruppe der ermittelten Entwürfe gehören, zum Beispiel mittels der Eingabe einer Gruppenzugehörigkeit des Entwurfs zu einer Technologiegruppe, wie zum Beispiel Automobil, Marine, Windkraft, Energieerzeugung oder zu Pneumatik, Hydraulik, Elektrik.

Auch mit diesen vorbestimmten Kriterien ist eine Bereitstellung kontextsensitiver Widgets über eine Mensch-Maschine-Schnittstelle möglich, insbesondere um Benutzerinteraktionen zu ermöglichen.

Die Bereitstellung kontextsensitiver Widgets in der Vorschau ermöglicht Benutzerinteraktionen über diese Widgets.

Die Darstellung dieser Widgets erfolgt vorzugsweise durch ein Anzeigegerät wie einen Monitor, ein VR-Gerät oder andere geeignete Anzeigemittel.

Die Extraktion von Daten kann vorzugsweise durch ein Design-Erhebungs-Modul (Design-Extractor-Module) aus der genannten Entwurfsdatenbank, die auch als Entwurfssammlung bezeichnet werden kann, erfolgen. Die Entwurfssammlung dient den Ingenieur in der täglichen Arbeit als Speicher für die Entwürfe.

Die Bereitstellung kontextbasierter Informationen in einem erweiterten Vorschau-Bild kann vorzugsweise durch ein Entwurfshilfemodul erfolgen.

Gemäß einer vorteilhaften Weiterbildung kann die Verwendungsempfehlung mittels eines Künstliche-Intelligenz-Moduls ermittelt werden, das bevorzugt die Häufigkeit bisheriger bzw. der ermittelten Entwürfe und/oder deren Ähnlichkeit mit dem in der Entwurfsphase befindlichen Entwurf berücksichtigt bzw. als Eingabe erhält. Der Grad der Ähnlichkeit kann hierbei beispielsweise begründet sein in einer Ähnlichkeit des Technologiegebiets des Entwurfsprojektes mit denen der ermittelten Entwürfe und/oder mit der Anzahl der verwendeten Designelemente und/oder durch eine Größenordnung physikalischer Parameter. Die Künstliche-Intelligenz zur Ermittlung einer geeigneten Verwendungsempfehlung für den Benutzer kann trainiert werden mittels Benutzerverhaltens, insbesondere übergreifend über mehrere Benutzer, besonders bevorzugt übergreifend über mehrere Instanzen der computergestützten Entwurfsumgebung, jedenfalls erfindungsgemäß unter Zugriff auf in der Designdatenbank enthaltene Informationen aus der Entwurfsdatenbank.

Eine vorteilhafte Weiterbildung der Erfindung sieht vor, dass das Verfahren in einer
(a) Datenerhebungsphase diese weiteren Schritte umfasst:
   (a1) Auswählen eines Entwurfs aus der Entwurfsdatenbank,
   (a2) Extrahieren von Daten aus dem ausgewählten Entwurf,
   (a3) Umwandlung dieser Daten in ein Graphdatenbank-Format,
   (a4) Speicherung dieser umgewandelten Daten in einer Designdatenbank, wobei die Designdatenbank als Graphdatenbank ausgebildet ist.

Bei der Auswahl des Entwurfs kann bevorzugt ein Auswahlmodul vorbestimmte Kriterien benutzen, die die Datenerhebung priorisieren. Alternativ können die Entwürfe in einer sortierten Reihenfolge abgearbeitet werden.

Zweckmäßig kann eine vorteilhafte Weiterbildung der Erfindung vorsehen, dass Schritt (a2) umfasst:
- Erstellung einer Bilddatei des in Schritt (a1) ausgewählten Entwurfs,
- Ermitteln der in diesem Entwurf enthaltenen Entwurfselemente und deren Anordnung in dem Bild der Bilddatei.

Die Bilddatei kann als eine einfache Pixel-Datei (zum Beispiel PNG, JPG) beispielsweise als Export oder Aufnahme erstellt werden. Die einzelnen Entwurfselemente können anhand ihrer charakteristischen Symbolik erkannt werden und die Anordnung sowie ihre flächenmäßige Erstreckung dann als zusätzliche Information der Bilddatei zugeordnet werden.

Eine weitere vorteilhafte Weiterbildung der Erfindung sieht vor, dass Schritt (a2) umfasst:
- Serialisierung der Bilddatei in eine String-Image-Datei.

Diese Formatumwandlung ermöglicht das Ablegen dieser Daten in einer Graphdatenbank - besonders bevorzugt in der Art eines Knowledgegraphs.

Die Erfindung löst die sich aus den Problemen des Standes der Technik ergebende Aufgabe dadurch, dass eine Designdatenbank Informationen aus der Entwurfsdatenbank über Entwürfe enthält,
(b) das Verfahren in einer Entwurfsphase weitere Schritte umfasst:
(b1) Auswählen mindestens eines Entwurfselements,
(b2) Ermitteln von Entwürfen, die das ausgewählte Entwurfselement enthalten, aus der Designdatenbank,
(b3) Anzeigen von Informationen betreffend mindestens einen der ermittelten Entwürfe.

Eine vorteilhafte Weiterbildung der Erfindung sieht vor, dass Schritt (b3) umfasst:
(b31) Ermitteln von Informationen über Entwurfselemente, die in den in Schritt (b2) ermittelten Entwürfen an dem in Schritt (b1) ausgewählten Entwurfselement angrenzend angeordnet sind,
(b32) Anzeigen der in Schritt (b31) ermittelten Informationen betreffend mindestens ein Entwurfselement.

Diese Hinweise auf besonders bevorzugte angrenzende Bauteile sind für den Benutzer - besonders für den nicht erfahrenen Benutzer - besonders zeitsparend, weil in der Vielzahl der Entwurfselemente, die die Entwurfselementesammlung zur Verfügung stellt, die Suche nach einem passenden Entwurfselement besonders zeitraubend ist.

Eine vorteilhafte Weiterbildung der Erfindung sieht vor, dass zu den Informationen über eine Verwendung des angrenzend angeordneten Entwurfselements als angrenzendes Entwurfselement zu dem ausgewählten Entwurfselement eine Statistik oder eine Häufigkeit
in den ermittelten Entwürfen oder
in einer Untergruppe der ermittelten Entwürfe ermittelt und angezeigt wird.

Bei einer grundlegenden Analyse hatte sich gezeigt, dass viele Entwurfselemente in unterschiedlichen Entwürfen häufig mit den gleichen Nachbarn vorkommen. Daher ist es für einen Benutzer nützlich, Hinweise zur Häufigkeit der Benutzung entsprechender angrenzender Entwurfselemente für das aktuelle Entwurfselement zu bekommen, sodass dieser Hinweis entsprechend oft zu der gewünschten Zeitersparnis führt.

Eine vorteilhafte Weiterbildung der Erfindung sieht vor, dass zu den Informationen über eine Verwendung des angrenzend angeordneten Entwurfselements als angrenzendes Entwurfselement zu dem ausgewählten Entwurfselement eine Verwendungsempfehlung als angrenzendes Entwurfselement zu dem ausgewählten Entwurfselement ermittelt und angezeigt wird. Eine Verwendungsempfehlung kann durch einen entsprechenden Agenten bzw. ein Empfehlungsmodul (Design-Recommender) dem Benutzer angezeigt werden. Das Empfehlungsmodul kann hierbei ein trainiertes KI-Modul sein, das permanent aus dem Benutzerverhalten und/oder durch Analyse vorhandener Entwürfe aus der Designdatenbank und/oder der Entwurfsdatenbank zum Zwecke der Verbesserung des Empfehlungsalgorithmus lernt.

Eine vorteilhafte Weiterbildung der Erfindung sieht vor, dass mindestens ein vorbestimmtes Gruppenkriterium die Untergruppe der ermittelten Entwürfe definiert.

Eine vorteilhafte Weiterbildung der Erfindung sieht vor, dass dem Benutzer eine der folgenden Optionen angeboten wird:
- mindestens ein angrenzendes Entwurfselement oder
- mindestens ein angrenzendes Entwurfselement und weitere an das angrenzende Entwurfselement angrenzende Entwurfselemente
aus den ermittelten Entwürfen benachbarter Entwurfselemente zur Anordnung in dem in der Entwurfsphase befindlichen Entwurf zu übernehmen. Sowohl die einzelne Übernahme als auch die Übernahme mehrerer Elemente oder ganzer Restentwürfe kann dem Benutzer viel Zeit ersparen, insbesondere, wenn der in der Entwurfsphase befindliche Entwurf einem bereits vorhandenen Entwurf stark ähnelt.

Eine vorteilhafte Weiterbildung der Erfindung sieht vor, dass das virtuelle Modell ein Simulationsmodell ist zur Durchführung einer Simulation einer Verwendung des Bauteils mittels mindestens eines Computers. Die Verwendung des Bauteils kann sich hierbei auf einzelne Teile eines technischen Systems beziehen oder auf technische Gesamtprodukte in einer Umgebung, die der typischen Betriebsumgebung entspricht.

Eine vorteilhafte Weiterbildung der Erfindung sieht vor, dass durch den Benutzer in der Entwurfsphase für ein bestimmtes Entwurfselement automatisch oder manuell eine Abfrage in der Designdatenbank veranlassbar ist, mittels derer die Verwendung des Entwurfselements in früheren Entwürfen untersucht wird. Hierzu kann die Entwurfsumgebung ein Entwurfselement-Detektor-Modul enthalten, das automatisch Entwürfe aus der Designdatenbank unter Verwendung des Entwurfselements desselben Typs aus der Designdatenbank abruft.

Eine vorteilhafte Weiterbildung der Erfindung sieht vor, dass das Auswählen eines angebotenen Entwurfs mit einem Entwurfselement die Erzeugung einer Vorschau, bevorzugt mittels eines Vorschaugenerators der Entwurfsumgebung, veranlasst, wobei der Vorschaugenerator bevorzugt zumindest einige, besonders bevorzugt alle der folgenden Schritte ausführt:
- De-serialisieren der String-Bild-Datei des ausgewählten Entwurfs in eine Bild-Datei,
- Abrufen von Geometrie-Eigenschaften (Koordinaten, Breite und Höhe) der Instanzen des mindestens einen Entwurfselements, das in dem gegenwärtigen Entwurf zur Übernahme angeboten wird,
- Anpassen der Geometrie des zur Übernahme angebotenen Entwurfselements an die Darstellung des Entwurfs, der das vorgeschlagene Entwurfselement verwendet hat (z. B. Anpassen Seitenverhältnisse und/oder Skalieren)
- Erstellung eines Bild-Overlays zur Überlagerung des zur Übernahme angebotenen Entwurfselements in einer Darstellung des Entwurfs, der das vorgeschlagene Entwurfselement verwendet hat und besonders bevorzugt Bereitstellung zusätzlicher Informationen zu dem vorgeschlagenen Entwurfselement (z.B. Parameter, Verhaltensmodelle, Dokumentationen),
- Zusammenführen des Bild-Overlays mit der Darstellung des Entwurfs, der das vorgeschlagene Entwurfselement verwendet hat, insbesondere um ein mit zusätzlichen Funktionen und/oder Informationen erweitertes Vorschaubild zu erstellen,
- Erzeugen von kontextsensitiven Widgets im erweiterten Vorschaubild, insbesondere um Benutzerinteraktionen zu ermöglichen.

Besonders bevorzugt erfolgt schließlich ein Auswählen (instanziieren) eines Entwurfselements in dem Vorschaubild und ein Festlegen mindestens eines Entwurfselement-Parameters.

Eine vorteilhafte Weiterbildung der Erfindung sieht die Durchführung des erfindungsgemäßen Verfahrens nach einem der Ansprüche und ggf. weitergebildet mittels einer in diesem Dokument beschriebenen Weiterbildung vor, wobei das Verfahren Bestandteil eines Verfahrens zur Verbesserung oder Optimierung des Bauteils ist. Im Einzelnen kann der Prozess zur Verbesserung oder Optimierung folgende Schritte umfassen, die bevorzugt wiederholt durchgeführt werden, so dass eine Iteration erfolgt:
- Festlegen eines Verbesserungsziels/Optimierungsziels
- Bereitstellen einer Startspezifikation des Bauteils
- Spezifizieren von Änderungen an dem Bauteil, sodass mehrere geänderte Bauteilspezifikationen sich ergeben
- Erzeugen der Modelle bzw. Simulationsmodelle nach dem erfindungsgemäßen Verfahren zum Erzeugen eines virtuellen Modells für jede Bauteilspezifikation,
- Simulieren des Betriebs der verschiedenen Bauteile
- Ermitteln der jeweiligen Annäherung an das Verbesserungsziel/Optimierungsziel für jedes einzelne Bauteil,
- Festlegen der Bauteilspezifikation, die die beste Annäherung erbracht hat als neue Startspezifikation oder als Ergebnis des Verfahrens zur Bauteil -Verbesserung oder - Optimierung.

Eine weitere vorteilhafte Weiterbildung der Erfindung sieht die Durchführung des erfindungsgemäßen Verfahrens nach einem der Ansprüche und ggf. weitergebildet mittels einer in diesem Dokument beschriebenen Weiterbildung vor, wobei das Verfahren Bestandteil eines Herstellungsverfahrens ist, das eine Verifizierung, Verbesserung oder Optimierung des herzustellenden Bauteils vorsieht, bevor das Bauteil mittels eines Fertigungsprozesses erzeugt wird. Der Fertigungsprozess kann hierbei bevorzugt ein additiver Fertigungsprozess sein oder additive Fertigungsschritte umfassen. Der Fertigungsprozess kann auch abschließend eine Montage mehrerer gegebenenfalls verschiedener Bauteile umfassen, die einzelnen oder in Kombination miteinander unter Anwendung von Modellen, die mittels des erfindungsgemäßen Verfahrens erzeugt worden sind, hinsichtlich ihrer Eignung und ihrer Vor- und Nachteile während des Betriebes mittels einer Simulation geprüft, verifiziert, verbessert oder optimiert worden sind.

Im Folgenden ist die Erfindung anhand eines speziellen Ausführungsbeispiels zur Verdeutlichung näher beschrieben. Es zeigen:
- Figur 1:: eine schematische, vereinfachte Darstellung des Ablaufs des erfindungsgemäßen Verfahrens, ein entsprechendes Computersystem zur Durchführung und ein Computerprogrammprodukt beinhaltend das Verfahren,
- Figuren 2, 3:: jeweils eine beispielhafte Darstellung der Bedien- und Informationsoberfläche der Entwurfsumgebung auf einem Bildschirm während der Durchführung des Verfahrens.

Funktionsgleiche Bauteile sind teilweise mit identischen Bezugszeichen versehen. Funktionsgleiche Bauelemente werden teilweise nicht in allen Figuren ausgewiesen und auch nicht zu jeder einzelnen Abbildung separat wiederholt erläutert. Es ist grundsätzlich davon auszugehen, dass diese Bauelemente in den unterschiedlichen Darstellungen jeweils eine im Wesentlichen gleiche Funktion aufweisen.

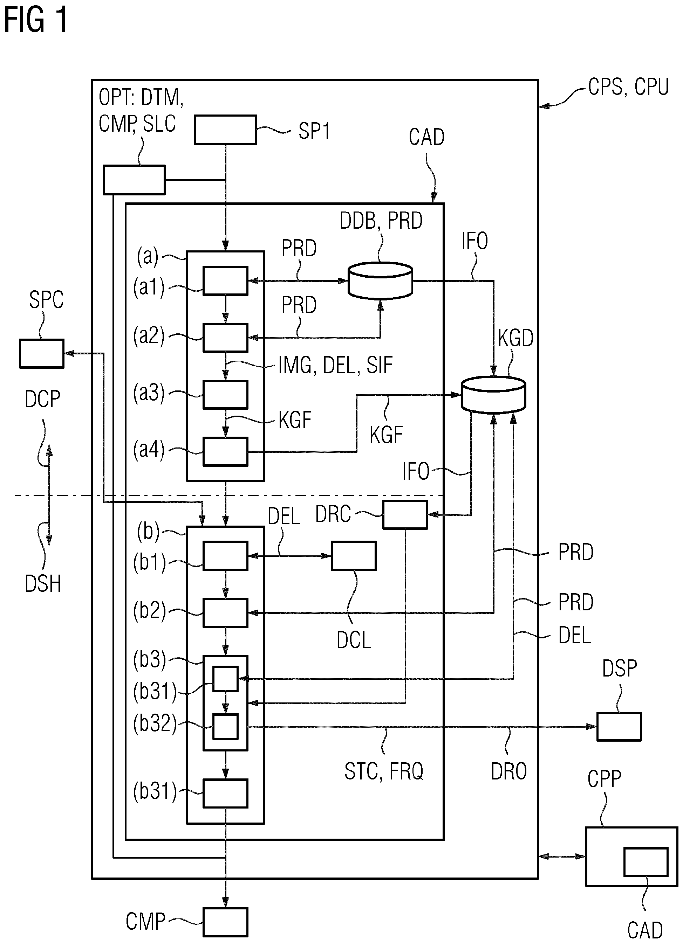

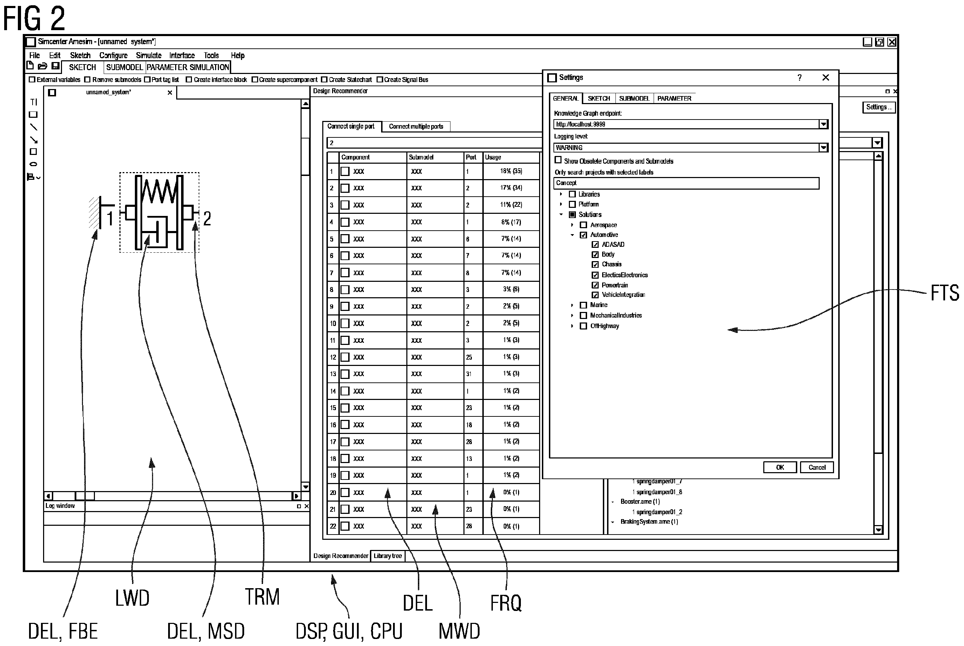

Figur 1 zeigt eine schematische, vereinfachte Darstellung des Ablaufs des erfindungsgemäßen Verfahrens, ein entsprechendes Computersystem CPS zur Durchführung und ein Computerprogrammprodukt CPP beinhaltend das Verfahren. Die Figuren 2 - 3 zeigen beispielhaft die auf einem Bildschirm DSP angezeigte Benutzeroberfläche GUI in beispielhaften Situationen während der Verfahrensdurchführung.

Das in Figur 1 illustrierte Verfahren dient zum Erzeugen eines virtuellen Modells MDL eines Bauteils CMP unter Verwendung einer computergestützten Entwurfsumgebung CAD, die eine Entwurfsdatenbank DDB umfasst. Dieses virtuelle Modell MDL ist ein Simulationsmodell zur Durchführung einer Simulation einer Verwendung des Bauteils CMP mittels mindestens eines Computers CPU. Die Entwurfsdatenbank DDB wird zum Speichern von Entwürfen DSG verwendet. Die Entwurfsdatenbank DDB stellt für die Entwurfsumgebung CAD vordefinierte Entwurfselemente DEL einer Entwurfselementesammlung DCL zur Verfügung. Zumindest einige der Entwürfe DSG umfassen vordefinierte Entwurfselemente DEL, bevorzugt umfassen alle Entwürfe DSG mehrere vordefinierte Entwurfselemente DEL.

Neben der Entwurfsdatenbank DDB ist erfindungsgemäß in der Entwurfsumgebung CAD eine Designdatenbank KGD vorgesehen, die Informationen IFO aus der Entwurfsdatenbank DDB über Entwürfe PRD enthält. Die Designdatenbank KGD ist als Graphdatenbank ausgebildet.

In einer Datenerhebungsphase DCP (a) umfasst das Verfahren die folgenden Schritte:
(a1) Auswählen eines Entwurfs PRD aus der Entwurfsdatenbank DDB,
(a2) Extrahieren von Daten aus dem ausgewählten Entwurf PRD,
(a3) Umwandlung dieser Daten in ein Graphdatenbank-Format KGF,
(a4) Speicherung dieser umgewandelten Daten in einer Designdatenbank KGD.

Weiterhin umfasst Schritt a2 folgende Zwischenschritte:
- Erstellung einer Bilddatei IMG des in Schritt al ausgewählten Entwurfs PRD,
- Ermitteln der in diesem Entwurf PRD enthaltenen Entwurfselemente DEL und deren Anordnung in dem Bild der Bilddatei IMG,
   - Serialisierung der Bilddatei IMG in eine String-Bild-Datei SIF.

In einer Entwurfsphase DSH (b) umfasst das Verfahren die weiteren Schritte:
(b1) Auswählen mindestens eines Entwurfselements DEL,
(b2) Ermitteln von Entwürfen PRD, die das ausgewählte Entwurfselement DEL enthalten, aus der Designdatenbank KGD,
(b3) Anzeigen von Informationen betreffend mindestens einen der ermittelten Entwürfe PRD mittels eines Bildschirms DSP.

Hierbei ist der Schritt (b3) in weitere Zwischenschritte untergliedert:
(b31) Ermitteln von Informationen über Entwurfselemente DEL, die in den in Schritt b2 ermittelten Entwürfen PRD an dem in Schritt b1 ausgewählten Entwurfselement DEL angrenzend angeordnet sind,
(b32) Anzeigen der in Schritt b31 ermittelten Informationen betreffend mindestens ein Entwurfselement DEL.

Dem Benutzer wird die Auswahl eines an das aktuelle Entwurfselement angrenzenden Entwurfselements erleichtert, indem zu den Informationen über eine Verwendung des angrenzend angeordneten Entwurfselements DEL als angrenzendes Entwurfselement DEL zu dem ausgewählten Entwurfselement DEL eine Statistik oder eine Häufigkeit
- in den ermittelten Entwürfen PRD oder
- in einer Untergruppe der ermittelten Entwürfe PRD ermittelt und angezeigt wird. Hierzu kann eine Verwendungsempfehlung DRO für ein Entwurfselement als angrenzendes Entwurfselement DEL zu dem ausgewählten Entwurfselement DEL ermittelt und angezeigt werden. Für die Definition einer Untergruppe der ermittelten Entwürfe PRD kann mindestens ein vorbestimmtes Gruppenkriterium vorgesehen sein. Dieses Gruppenkriterium kann beispielsweise durch den Benutzer für ein

Projekt oder für einzelne Bauteile festgelegt werden. Hierbei kann es sich beispielsweise um ein Anwendungsgebiet für dieses Bauteil handeln oder um ein Technologiefeld oder um eine bestimmte Herstellungsmethode oder um eine Kombination dieser Kriterien. Beispielsweise kann das Technologiefeld als Automobil definiert werden, sodass dem Benutzer beispielsweise für die Verwendungsempfehlung bevorzugt Entwurfselemente angeboten werden, die in einem entsprechenden Konstruktionszusammenhang (z.B. angrenzende(s) Entwurfselement(e)) ebenfalls für Automobil-bezogene Projekte benutzt worden sind. Diese Entwurfselemente DEL, also
- mindestens ein angrenzendes Entwurfselement DEL oder
- mindestens ein angrenzendes Entwurfselement DEL und weitere an das angrenzende Entwurfselement DEL angrenzende Entwurfselemente DEL
werden dem Benutzer zur Übernahme in den eigenen Entwurf angeboten, sodass der Benutzer diese aus den ermittelten Entwürfen benachbarter Entwurfselemente DEL zur Anordnung in dem in der Entwurfsphase DSH befindlichen Entwurf DSG übernehmen kann.

Der verwendete Computer CPU zum Betrieb der Entwurfsumgebung CAD kann als Computersystem CPS ausgebildet sein umfassend mindestens einen Computer CPU vorbereitet zur Ausführung der Entwurfsumgebung CAD. Dieses Computersystem CPS kann als Netzwerk mit mehreren Computern CPU ausgebildet sein, sodass Daten zwischen den einzelnen Computern CPU ausgetauscht werden können und ein gemeinschaftlicher Zugriff auf die Entwurfsdatenbank DDB und die Designdatenbank KGD erfolgt.

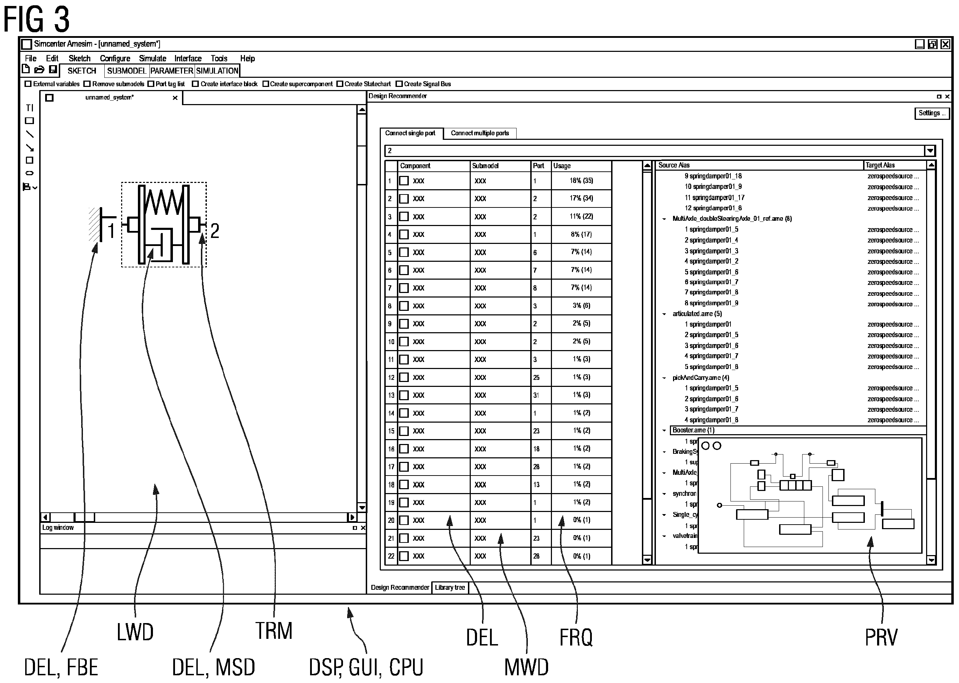

Figuren 2, 3 zeigen jeweils eine grafische Benutzeroberfläche GUI der Entwurfsumgebung CAD in unterschiedlichen Bediensituationen.

In den Figuren 2,3 ist in einem linken Fenster LWD ein Entwurfselement DEL als Masse-Feder-Dämpfer-System MSD ausgebildet. Links angrenzend an das Entwurfselement DEL ist ein weiteres Entwurfselement DEL als Festlager FBE angeordnet.

Dem Benutzer werden - dargestellt in Figur 2 - auf dem Bildschirm DSP - in einem zweiten von links gesehenen etwa mittig angeordnetem Fenster MWD - für einen zweiten Verbindungsendpunkt TRM potenziell geeignete Entwurfselemente DEL zur angrenzenden Anordnung vorgeschlagen. In der konkreten Bediensituation hat der Benutzer das erste angebotene Entwurfselement DEL ausgewählt und es werden Eigenschaften FTS dieses Entwurfselements DEL angezeigt. Die angebotenen Entwurfselemente DEL sind in einer Reihenfolge geordnet und nummeriert. Diese Reihenfolge richtet sich hier nach der Häufigkeit FRQ der Anordnung dieser in der Reihenfolge geordneten Entwurfselemente DEL hinsichtlich der Benutzung in einem vergleichbaren Entwurf aus der Designdatenbank KGD als angrenzendes Entwurfselement DEL.

Die Darstellung der Figur 3 zeigt eine Vorschau PRV bzw. ein Bild eines Entwurfs PRD, der aus der Designdatenbank KGD entstammt und die Anordnung des Entwurfselements DEL - wie in dem in der Entwurfsphase DSH befindlichen Entwurf - mit einem angrenzenden Entwurfselement DEL gemäß dem selektierten Vorschlag (hier der Vorschlag mit der Priorität 1) enthält. Auf diese Weise kann sich der Benutzer vergegenwärtigen, in welchem technischen Zusammenhang die vorgeschlagene Kombination von Entwurfselementen DEL in einem Entwurf schon einmal benutzt worden ist.

Vorliegend wurde die Erfindung in Bezug auf das beanspruchte Verfahren beschrieben. Merkmale, Vorteile oder alternative Ausführungsformen hierin können den anderen beanspruchten Gegenständen (z. B. dem Computerprogramm oder einer Vorrichtung, d. h. der Vorrichtung oder einem Computerprogrammprodukt) zugeordnet sein und umgekehrt. Mit anderen Worten, der Gegenstand, der in Bezug auf die Vorrichtung beansprucht oder beschrieben wird, kann mit Merkmalen verbessert werden, die im Zusammenhang mit dem Verfahren beschrieben oder beansprucht werden, und umgekehrt. In diesem Fall werden die funktionalen Merkmale des Verfahrens durch strukturelle Einheiten des Systems bzw. umgekehrt verkörpert. Im Allgemeinen sind in der Informatik eine Softwareimplementierung und eine entsprechende Hardware-Implementierung gleichwertig. So kann beispielsweise ein Verfahrensschritt zum "Speichern" von Daten mit einer Speichereinheit und entsprechenden Anweisungen zum Schreiben von Daten in den Speicher durchgeführt werden. Zur Vermeidung von Redundanz kann die Vorrichtung auch in den unter Bezugnahme auf das Verfahren beschriebenen alternativen Ausführungsformen verwendet werden, diese Ausführungsformen werden für die Vorrichtung nicht nochmals explizit beschrieben.

Es ist Bestandteil der Erfindung, dass nicht alle Schritte des Verfahrens notwendigerweise auf derselben Computerinstanz ausgeführt werden müssen, sondern auch auf verschiedenen Computerinstanzen ausgeführt werden können. Hierzu kann bevorzugt ein Netzwerk mit Computern genutzt werden.

Hierbei ist es insbesondere möglich, dass einzelne Schritte des oben beschriebenen Verfahrens in einer Einheit und die restlichen Schritte in einer anderen Einheit als verteiltes System durchgeführt werden können.

Die oben beschriebenen Eigenschaften, Merkmale und Vorteile dieser Erfindung sowie die Art und Weise, wie sie erreicht werden, werden im Lichte der folgenden Beschreibung und Ausführungsformen, die im Kontext der Zeichnungen näher beschrieben werden, klarer und verständlicher.

## Patentansprüche

**1.** Verfahren zum Erzeugen eines virtuellen Modells (MDL) eines Bauteils (CMP) unter Verwendung einer computergestützten Entwurfsumgebung (CAD), die eine Entwurfsdatenbank (DDB) umfasst,
wobei die Entwurfsdatenbank (DDB) zum Speichern von Entwürfen (DSG) verwendet wird,
wobei die Entwurfsumgebung (CAD) vordefinierte Entwurfselemente (DEL) einer Entwurfselementesammlung (DCL) zur Verfügung stellt,
wobei zumindest einige der Entwürfe (DSG) vordefinierte Entwurfselemente (DEL) umfassen,
**dadurch gekennzeichnet, dass**
eine Designdatenbank (KGD) Informationen (IFO) aus der Entwurfsdatenbank (DDB) über Entwürfe (PRD) enthält,
(b) das Verfahren in einer Entwurfsphase (DSH) weitere Schritte umfasst:
(b1) Auswählen mindestens eines Entwurfselements (DEL),
(b2) Ermitteln von Entwürfen (PRD), die das ausgewählte Entwurfselement (DEL) enthalten, aus der Designdatenbank (KGD),
(b3) Anzeigen von Informationen betreffend mindestens
einen der ermittelten Entwürfe (PRD).

**2.** Verfahren nach Anspruch 1,
wobei das Verfahren in einer
(a) Datenerhebungsphase (DCP) weitere Schritte umfasst:
(a1) Auswählen eines Entwurfs (PRD) aus der Entwurfsdatenbank (DDB),
(a2) Extrahieren von Daten aus dem ausgewählten Entwurf (PRD),
(a3) Umwandlung dieser Daten in ein Graphdatenbank-Format (KGF),
(a4) Speicherung dieser umgewandelten Daten in einer Designdatenbank (KGD), wobei die Designdatenbank (KGD) als Graphdatenbank ausgebildet ist.

**3.** Verfahren nach Anspruch 2,
wobei Schritt (a2) umfasst:
- Erstellung einer Bilddatei (IMG) des in Schritt (a1) ausgewählten Entwurfs (PRD),
- Ermitteln der in diesem Entwurf (PRD) enthaltenen Entwurfselemente (DEL) und deren Anordnung in dem Bild der Bilddatei (IMG).

**4.** Verfahren nach Anspruch 3,
wobei Schritt (a2) umfasst:
- Serialisierung der Bilddatei (IMG) in eine String-Bild-Datei (SIF).

**5.** Verfahren nach einem der vorhergehenden Ansprüche, wobei Schritt (b3) umfasst:
(b31) Ermitteln von Informationen über Entwurfselemente (DEL), die in den in Schritt (b2) ermittelten Entwürfen (PRD) an dem in Schritt (b1) ausgewählten Entwurfselement (DEL) angrenzend angeordnet sind,
(b32) Anzeigen der in Schritt (b31) ermittelten Informationen betreffend mindestens ein Entwurfselement (DEL).

**6.** Verfahren nach Anspruch 5, wobei zu den Informationen über eine Verwendung eines Entwurfselements (DEL) als angrenzendes Entwurfselement (DEL) zu dem ausgewählten Entwurfselement (DEL)eine Statistik (STC) oder eine Häufigkeit (FRQ)
in den ermittelten Entwürfen (PRD) oder
in einer Untergruppe der ermittelten Entwürfe (PRD) ermittelt und angezeigt wird.

**7.** Verfahren nach Anspruch 5, wobei zu den Informationen über eine Verwendung eines Entwurfselements (DEL) als angrenzendes Entwurfselement (DEL) zu dem ausgewählten Entwurfselement (DEL) eine Verwendungsempfehlung (DRO) als angrenzendes Entwurfselement (DEL) zu dem ausgewählten Entwurfselement (DEL) ermittelt und angezeigt wird.

**8.** Verfahren nach Anspruch 6, wobei mindestens ein vorbestimmtes Gruppenkriterium eine Untergruppe der ermittelten Entwürfe (PRD) definiert.

**9.** Verfahren nach Anspruch 5, 6 oder 7, umfassend:
dem Benutzer anbieten,
- mindestens ein angrenzendes Entwurfselement (DEL) oder
- mindestens ein angrenzendes Entwurfselement (DEL) und weitere an das angrenzende Entwurfselement (DEL) angrenzende Entwurfselemente (DEL)
aus den ermittelten Entwürfen benachbarter Entwurfselemente (DEL) zur Anordnung in dem in der Entwurfsphase (DSH) befindlichen Entwurf (DSG) zu übernehmen.

**10.** Verfahren nach einem der vorhergehenden Ansprüche, wobei das virtuelle Modell (SMD) ein Simulationsmodell ist zur Durchführung einer Simulation einer Verwendung des Bauteils (CMP) mittels mindestens eines Computers (CPU).

**11.** Computersystem (CPS) umfassend mindestens einen Computer (CPU) vorbereitet zur Durchführung des Verfahrens nach mindestens einem der vorhergehenden Ansprüche 1 bis 10.

**13.** Computerprogrammprodukt (CPP), das direkt in den internen Speicher eines Computers (CPU) geladen werden kann und computerlesbare Programmmittel umfasst, mit denen die Schritte des Verfahrens nach mindestens einem der vorhergehenden Ansprüche 1 bis 10 ausgeführt werden, wenn das Produkt auf einem Computer (CPU) läuft.
